# EUROPEAN PATENT APPLICATION

(11) **EP 2 077 448 A1**
(43) Date of publication of application: **08.07.2009**
(21) Application number: 07830354.2
(22) Date of filing: 23.10.2007
(51) Int. Cl.: G01N 22/00

(54) **WHOLE-BODY PHANTOM AND PROCESS FOR PRODUCING THE SAME**

(30) Priority: 25.10.2006 JP 2006289490
(71) Applicant: Kabushiki Kaisha Fine Rubber Kenkyuusho, Saitama-shi, Saitama 3300801 (JP)
(72) Inventor: KOYAMASHITA, Yuji, Saitama-shi Saitama 3300801 (JP); ARAI, Yoshikatsu, Saitama-shi Saitama 3300801 (JP)
(74) Representative: Naylor, Matthew John
(86) International application number: PCT/JP2007/070620
(87) International publication number: WO 2008/050749

(57) **Abstract**

Solving Means A whole-body phantom A **characterized by** being obtained from a conductive rubber material comprising a rubber base and a conductive filler incorporated therein by molding the rubber material so as to copy the whole shape of a human body; and a process for producing a whole-body phantom, **characterized by** using a mold which conforms to the shape of a human body and is made of a fiber-reinforced plastic.

Effect The whole-body phantom enables, with satisfactory handling, an examination of, e.g., influences of electromagnetic waves on the human body in various poses. The process for whole-body phantom production is suitable for use in producing such whole-body phantom.

## Description

### Technical Field

The present invention relates to a whole-body phantom and a process for producing the same, and particularly to a whole-body phantom which enables measurement of, e.g., influences of electromagnetic waves on a human body in various poses and a process for producing a whole-body phantom suitable as a process for producing such whole-body phantom.

### Background Art

In the past, as phantoms copying the head shape of a human body and the like, those formed of various materials made to be similar in electric characteristics to the human body have been developed. For example, Patent Document 1 discloses a technology for fabricating a phantom for a high-water-content tissue such as muscle and skin and a phantom for a low-water-content tissue such as fat and bone by use of a polymeric material containing a conductive filler and exhibiting rubber elasticity after cured. According to this technology, the document describes, it is possible to easily mold a phantom with a complicated shape such as the head shape. In addition, Patent Document 2, for example, discloses a technology in which molded bodies copying some parts of a human body are obtained using thermosetting resins loaded with a conductive filler, and the molded bodies copying the human body parts are combined with each other to form a predetermined shape. In the case of this technology, a phantom for the upper half of the human body is described in the document. Further, Patent Document 3 discloses a living body approximation phantom for ultrasonic medicine, in which an internal-organ model obtained by molding gelatin into the shape of an internal organ of the human body and insolubilizing the molded body is incorporated in a trunk model obtained by molding gelatin into the shape of the trunk of the human body and insolubilizing the molded body. Furthermore, Patent Document 4 discloses a pseudo human body device including a head portion, a trunk portion, a right shoulder portion, a left shoulder portion and a right arm portion which are filled respectively with human body-equivalent materials such as physiological saline, water, etc.
Patent Document 1: Japanese Patent Laid-open No. Hei 10-170454
Patent Document 2: Japanese Patent Laid-open No. 2000-82333
Patent Document 3: Japanese Patent Laid-open No. 2005-118187
Patent Document 4: Japanese Patent Laid-open No. 2004-286735

### Disclosure of Invention

### Problems to Be Solved by the Invention

On the other hand, attendant on the advance of technology recently, there is a request for development of a whole-body phantom copying the whole shape of a human body, for the purpose of examining, for example, influences of electromagnetic waves on the human body in everyday life.

However, the above-mentioned technologies are each aiming at copying the head shape or the upper-half shape of a human body, and the above-mentioned documents contain no description of a phantom so formed as to copy the whole shape of a human body. Besides, in the technologies disclosed in Patent Documents 3 and 4, difficulties in the production process and/or variations in electric characteristics made it difficult to produce a phantom which is comparable in size to the whole shape of a human body. For instance, assuming that a whole-body phantom copying the whole shape of a human body is produced using a gelled material such as gelatin and agar-agar described in Patent Document 3 and is put to use, in the case of a so-called wet-type phantom as described, there would occur the problem that the phantom is dried with time, resulting in variations in the electric characteristics of the phantom. In addition, use of the phantom in a standing posture, for example, is considered to be difficult, since the material used in this case is unsatisfactory for maintaining the shape of the phantom. On the other hand, by applying the technology in which vessels copying the shapes of human body parts are filled with human body-equivalent materials such as physiological saline and water as in Patent Document 4, for example, a case may be assumed in which a vessel copying the whole shape of a human body is prepared and filled with the above-mentioned liquid to obtain a so-called liquid-type whole-body phantom. In this case, for example, application of electromagnetic waves to the head portion causes heating of the head portion and, hence, convection of the liquid therein, probably making nonuniform the electric characteristics of the liquid inside. Besides, in the case of electromagnetic wave measurement, the influences of the electromagnetic waves on the deep part of the human body differ depending on the frequency of the waves used. Therefore, such a liquid-type phantom is limited in use. Means for Solving the Problems

In order to attain the above object, the present inventors made intensive and extensive investigations, and, as a result of the investigations, have made the following inventions pertaining to a whole-body phantom and the following inventions pertaining to a process for producing a whole-body phantom. First, as one of inventions pertaining to a whole-body phantom, Invention 1 resides in a whole-body phantom obtained from a conductive rubber material having a rubber base loaded with a conductive filler by molding the rubber material so as to copy the whole shape of a human body. Invention 2 resides in a whole-body phantom according to Invention 1, wherein the conductive rubber material is laminated on a surface of a hollow-shaped fiber-reinforced plastic body molded so as to copy the whole shape of a human body. Invention 3 resides in a whole-body phantom according to Invention 2, wherein the hollow part of the fiber-reinforced plastic molded body is further filled with the conductive rubber material or a polymeric foam material. Invention 4 resides in a whole-body phantom according to Invention 1, obtained by molding the conductive rubber material into a solid shape so as to copy the whole shape of a human body. Invention 5 resides in a whole-body phantom according to Invention 1, obtained by molding the conductive rubber material so as to copy the whole shape of a human body and to have a hollow part, and filling the hollow part with a polymeric foam material so as to form a solid shape copying the whole shape of the human body. Invention 6 resides in a whole-body phantom according to any of Inventions 1 to 5, wherein a part corresponding to an arm can be detachably attached to a part corresponding to a trunk. Invention 7 resides in a whole-body phantom according to any of Inventions 1 to 6, wherein a part corresponding to an upper half of the human body and a part corresponding to a lower half of the human body can be detachably attached to each other. Invention 8 resides in a whole-body phantom according to any of claims 1 to 7, wherein the conductive rubber material has electric characteristics similar to those of muscle, fat or skin of a human body. Invention 9 resides in a whole-body phantom according to any of claims 2, 3 and 6 to 8, wherein the fiber-reinforced plastic has electric characteristics similar to those of bones of a human body. Invention 10 resides in a whole-body phantom according to Invention 8 or 9, obtained through lamination of at least two materials selected from the group composed of the conductive rubber material having electric characteristics similar to those of muscle, fat or skin of a human body and the fiber-reinforced plastic having electric characteristics similar to those of bones of a human body.

In the next place, as one of inventions pertaining to a process for producing a whole-body phantom, Invention 11 resides in a process for producing a whole-body phantom according to any of Inventions 1 to 10, wherein a mold made of a fiber-reinforced plastic and corresponding to the outer shape of a human body is used. Invention 12 resides in a process for producing a whole-body phantom according to Invention 11, including the steps of filling the space between an outer mold made of a fiber-reinforced plastic and corresponding to the outer shape of a human body and an inner mold made of a fiber-reinforced plastic and corresponding to the outer mold with an uncured conductive rubber material having an uncured rubber base loaded with a conductive filler, curing the conductive rubber material, and leaving the inner mold inside the cured conductive rubber material. Invention 13 resides in a process according to Invention 12, further including the step of filling a hollow part defined by the inner mold with the conductive rubber material or a polymeric foam material. Invention 14 resides in a process according to Invention 11, wherein a conductive rubber material having an uncured rubber base loaded with a conductive filler is applied to, laminated on or laid along inner surfaces of a pair of outer molds formed of a fiber-reinforced plastic and corresponding to the outer shape of a human body when mated to each other, the outer molds are mated to each other so as to define a hollow part by the conductive rubber material, and the hollow part is filled with a polymeric foam material.

The present inventors found out that, with the whole-body phantom configured as above, it is possible to obtain a whole-body phantom which has electric characteristics similar to those of a human body, enables accurate measurement and/or observation of influences of electromagnetic waves, radio waves or the like on a human body in various poses, is light in weight and is therefore satisfactory in handleability. The present inventors also found out that the whole-body phantom as above-mentioned can be favorably produced by the process for producing a whole-body phantom configured as above. Based on the findings, the present invention has been made.

Specifically, the present invention provides (1) a whole-body phantom obtained from a conductive rubber material having a rubber base loaded with a conductive filler by molding the rubber material so as to copy the whole shape of a human body. More specifically, the whole-body phantom according to the present invention is a whole-body phantom obtained by laminating the conductive rubber material on a surface of a hollow-shaped fiber-reinforced plastic body molded so as to copy the whole shape of a human body. Further, the whole-body phantom may be a whole-body phantom in which the hollow part of the fiber-reinforced plastic molded body is filled with the conductive rubber material or a polymeric foam material; in this case, the whole-body shape is made stable. In addition, the whole-body phantom may be obtained by molding the conductive rubber material into a solid shape copying the whole shape of a human body. Besides, the whole-body phantom having the solid shape may be obtained by molding the conductive rubber material so as to copy the whole shape of a human body and to have a hollow part, and filling the hollow part formed inside the outer mold with a polymeric foam material so that the whole-body phantom having the solid shape thus obtained is ultra-lightweight.

Further, when a part corresponding to an arm can be detachably attached to a part corresponding to a trunk, the whole-body phantom can be changed over into various poses differing in the bending position and/or shape of the arm, which naturally is preferable. In addition, when a part corresponding to the upper half of a human body and a part corresponding to the lower half of a human body can be detachably attached to each other, i.e., when an upper trunk can be detachably attached to a lower trunk, the pose of the whole-body phantom can be changed by replacement among the lower halves of the human body which have different shapes corresponding to a sitting posture, a standing posture, and various working postures, respectively, which naturally is more preferable. Further, when the rubber material has electric characteristics similar to (hereinafter referred to also as "equivalent to") those of muscle, fat or skin of a human body or when the fiber-reinforced plastic has electric characteristics similar to those of bones of a human body, a phantom is obtained the inside of which also has electric characteristics similar to those of the inside of a human body. Furthermore, when at least two materials selected from the group composed of the conductive rubber material having electric characteristics similar to those of muscle, fat or skin of a human body and the fiber-reinforced plastic having electric characteristics similar to those of bones of a human body are laminated to form a whole-body phantom having the inside and a surface similar to the tissues of a human body, a real phantom having characteristics closer to those of a human body can be obtained, which is particularly preferable.

Furthermore, the present invention provides (2) a process for producing a whole-body phantom described in (1) above, wherein a mold made of a fiber-reinforced plastic and corresponding to the outer shape of a human body is used. Here, as the process for producing a whole-body phantom having a hollow-shaped fiber-reinforced plastic body molded so as to copy the whole shape of a human body, a process for producing a whole-body phantom, including the steps of filling the space between an outer mold made of a fiber-reinforced plastic and corresponding to the outer shape of a human body and an inner mold made of a fiber-reinforced plastic and corresponding to the outer mold with an uncured conductive rubber material having an uncured rubber base loaded with a conductive filler, curing the conductive rubber material, and leaving the inner mold inside the cured conductive rubber material, is preferable because the inner mold functions as aggregate. In addition, a process for producing a whole-body phantom, including the step of filling a hollow part defined by the inner mold with the conductive rubber material or a polymeric foam material, is also preferable. Furthermore, a process for producing an ultra-lightweight whole-body phantom wherein a conductive rubber material having an uncured rubber base loaded with a conductive filler is applied to, laminated on or laid along inner surfaces of a pair of outer molds formed of a fiber-reinforced plastic and corresponding to the outer shape of a human body when mated to each other, the outer molds are mated to each other so as to define a hollow part by the conductive rubber material, and the hollow part is filled with a polymeric foam material, is also preferable. Incidentally, in this producing process, the step in which the conductive rubber material having an uncured rubber base loaded with a conductive filler is "applied to, laminated on or laid along the inner surfaces of the outer molds" means a step in which the conductive rubber material having an uncured rubber base loaded with a conductive filler is attached to the inner surfaces of the outer molds so that the conductive rubber material can be peeled off from the outer molds after cured. More specifically, it means that the uncured conductive rubber material is applied to the inner surfaces of the outer molds in a large thickness so as to have a predetermined thickness (material thickness) after cured as will be described later, that at least one uncured conductive rubber material is laminated on the inner surfaces of the outer molds so as to form at least one conductive rubber material layer on the inner surfaces of the outer molds, or that an uncured conductive rubber material formed in a sheet-like shape is adhered to (laid on) the inner surfaces of the outer molds as will be described later.

According to the whole-body phantom of the present invention, the conductive rubber material having a rubber base loaded with a conductive filler is molded so as to copy the whole shape of a human body, so that the conductive rubber material is present at the surface of the human body phantom. Therefore, as contrasted to the case of a whole-body phantom having a vessel shaped to copy the shape of a human body and filled with a liquid, the absence of any vessel in the present case enables measurement of influences of, e.g., electromagnetic waves on the surface of a human body.

Here, when the whole-body phantom according to the present invention is one in which the conductive rubber material is laminated on the surface of the hollow-shaped fiber-reinforced plastic body molded so as to copy the whole shape of a human body, the fiber-reinforced plastic functions as a reinforcement, making it possible to examine the influences of electromagnetic waves or the like on a human body in a standing posture, for example. Thus, the phantom can be used as a standing-type whole-body phantom. Meanwhile, for example, since the human body itself is a conductor, the presence of a human body or bodies causes variations in radio wave characteristics. Particularly, in an enclosed space surrounded by a wall such as in the inside of a room, a vehicle, an elevator, a tramcar, an aircraft, etc., electromagnetic waves are expected to be easily varied by the presence of a human body or bodies. However, according to the standing-type (standing posture type) whole-body phantom, the variations in electromagnetic waves can be examined by attaching a sensor, a measuring instrument or the like to, for example, the wall of the enclosed space, providing the condition where the standing-type (standing posture type) whole-body phantom in the enclosed space is using or carrying an electromagnetic wave generating device, and examining the electromagnetic waves. In addition, in the case of a high-frequency wave phantom corresponding to radio waves, electromagnetic waves or the like for communication such as those of a cellular phone or radio waves, electromagnetic waves or the like for identification such as those for a radar, measurement at the body surface only suffices. Therefore, the whole-body phantom can be used as a high-frequency wave phantom by providing the conductive rubber material laminated on the surface of the fiber-reinforced plastic molded body with predetermined electric characteristics. Further, since the whole-body phantom has the fiber-reinforced plastic in a hollow shape, the cavity may be utilized, for example, by disposing a sensor, a measuring instrument or the like in the cavity, whereby influences of electromagnetic waves exerted on the inside of a human body from the outside of the human body can also be examined. Thus, it is possible, for example, to examine the influences of electromagnetic waves on a pacemaker by attaching a sensor, a measuring instrument or the like to a heart portion of the hollow whole-body phantom, or to examine the influences of electromagnetic waves on a fetus by providing a whole-body phantom copying the shape of a pregnant woman and attaching a sensor, a measuring instrument or the like to an abdominal portion of the phantom. In the whole-body phantom in which a vessel copying the shape of a human body is filled with a liquid according to the related art, the thick portion provided with electric characteristics is in close relation with the accuracy of the vessel. On the contrary, in the case of the whole-body phantom in which the conductive rubber material is laminated on the surface of the fiber-reinforced plastic molded body, it is possible to modify the phantom according to an objective frequency by only varying the thickness of the conductive rubber material.

On the other hand, further, a whole-body phantom in which a hollow part of the inner mold of the fiber-reinforced plastic molded body is filled with a conductive rubber material can similarly be used as a standing-type (standing posture type) whole-body phantom. Particularly, in the case of examining the influences of low-frequency electromagnetic waves or radio waves on a human body, measurement at not only the surface of the human body but also the whole part of the human body is more preferable. In view of this, the whole body phantom is more useful as a low-frequency wave phantom. Incidentally, where the whole-body phantom is used in this manner, providing the fiber-reinforced plastic with electric characteristics similar to those of bones of a human body as will be described later is further preferable. In addition, a whole-body phantom in which a hollow part of the fiber-reinforced plastic molded body is filled with a polymeric foam material has an advantage in that lightweightness can be maintained and strength can be increased.

The whole-body phantom according to the present invention can be a whole-body phantom in which the conductive rubber material is molded to be a solid shape copying the whole shape of a human body. Such a phantom can be favorably used as a lying-type whole-body phantom for examining the influences of electromagnetic waves on a human body in a lying posture. Besides, a whole-body phantom in which the conductive rubber material is molded so as to copy the whole shape of a human body and to have a hollow part and the hollow part in the whole shape part is filled with the polymeric foam material to form a solid shape is an ultra-lightweight whole-body phantom.

Furthermore, a whole-body phantom according to the present invention wherein a part corresponding to an arm can be detachably attached to a part corresponding to a trunk is easy to use in various conditions, for example, a condition where a person is talking over a cellular phone or a condition where a person is utilizing a mailing function of a cellular phone. Further, where a hand and an arm can be detachably attached to each other at the wrist position, replacement of the hand according to various cellular-phone shapes enables accurate measurement and enhances utility. In addition, where a part corresponding to the upper half of the human body and a part corresponding to the lower half of the human body can be detachably attached to each other, the whole-body phantom can be easily used in various human-body poses, for example, a standing pose, a sitting pose (the pose of sitting on a floor or being seated on a chair), a pose of being seated on a vehicle seat, or a pose of being seated on a seat (saddle) of any of such various vehicles as motorcycle and bicycle.

Further, where the conductive rubber material in the whole-body phantom according to the present invention has electric characteristics similar to those of muscle, fat or skin of a human body, it is possible to perform measurement according to the electric characteristics of each part of a human body. Where the fiber-reinforced plastic of the whole-body phantom has electric characteristics similar to those of bones of a human body, the phantom can be used as a whole-body phantom with which influences of the bones inside a human body can be measured. Furthermore, where phantom parts are prepared according to parts of a human body so as to have electric characteristics similar to those of bone, muscle, fat and skin of a human body and at least two of the phantom parts are laminated in combination to form a phantom, it is possible to obtain a real phantom which can be tested in the condition where not only the surface but also the whole part of the whole-body phantom have electric characteristics more approximate to those of a human body.

The process for producing a whole-body phantom according to the present invention is not particularly limited. According to the process for producing a whole-body phantom of the present invention, a mold made of a fiber-reinforced plastic and corresponding to the outer shape of a human body is used. An outer mold made of a fiber-reinforced plastic and corresponding to the outer shape of a human body and an inner mold corresponding to the outer mold may be combined with each other. Or, alternatively, a mold (outer mold) made of a fiber-reinforced plastic and corresponding to the outer shape of a human body may be used alone, without using any inner mold. Incidentally, in the case of using the inner mold, if the inner mold is to be removed after molding of the conductive rubber material, the inner mold may not necessarily be made of a fiber-reinforced plastic. Taking productivity or the like into consideration, however, the inner mold is preferably made of a fiber-reinforced plastic. Particularly where the inner mold is to be left inside the conductive rubber material after curing of the latter, an inner mold made of a fiber-reinforced plastic is used. According to such a production process, the mold(s) is prepared by use of a fiber-reinforced plastic, so that it is easier to produce than a metallic die, even if the mold shape is complicated. Consequently, a rubber material can be easily molded into a complicated shape such as the whole shape of a human body.

Furthermore, in the case of a whole-body phantom in which the conductive rubber material is laminated on the surface of a hollow-shaped fiber-reinforced plastic body molded to copy the whole shape of a human body, the space between an outer mold made of a fiber-reinforced plastic and corresponding to the outer shape of a human body and an inner mold made of a fiber-reinforced plastic and corresponding to the outer mold is filled with an uncured conductive rubber material having an uncured rubber base loaded with a conductive filler, the conductive rubber material is cured, and the inner mold is left inside the conductive rubber material thus cured, whereby a whole-body phantom with a hollow-shaped fiber-reinforced plastic molded body incorporated therein can be produced favorably. Besides, where a hollow part of the fiber-reinforced plastic molded body is further filled with the conductive rubber material, the inner mold is filled with the conductive rubber material yet to be cured and is then cured, whereby a whole-body phantom is obtained in which the hollow part of the fiber-reinforced plastic molded body is filled with the conductive rubber material. In the case of the whole-body phantom in which the conductive rubber material is laminated on the surface of the hollow-shaped fiber-reinforced plastic body molded to copy the whole shape of a human body, it is possible to modify the whole-body phantom according to an objective frequency by only changing the thickness of the conductive rubber material, as above-mentioned. According to this production process, it is possible, for example, to easily vary the thickness of the conductive rubber material by only changing the size of the inner mold relative to the outer mold, and to obtain excellent accuracy of the thickness of the conductive rubber material. In addition, by injecting a polymeric foam material into the inside of the inner mold in place of the conductive rubber material, it is possible to obtain a solid-shaped whole-body phantom in which a hollow part of the fiber-reinforced plastic molded body is filled with the polymeric foam material.

Besides, another process for producing a whole-body phantom by molding the conductive rubber material into a solid shape copying the whole shape of a human body is a process in which a conductive rubber material having an uncured rubber base loaded with a conductive filler is applied to, laminated on or laid along the inner surface of a pair of outer molds formed of a fiber-reinforced plastic and corresponding to the outer shape of a human body when mated to each other, the outer molds are mated to each other to define a hollow part by the conductive rubber material, and the hollow part is filled with a polymeric foam material. Specifically, an uncured conductive rubber material having an uncured rubber base loaded with a conductive filler is applied in a predetermined thickness to the inner surfaces of the outer molds formed of a fiber-reinforced plastic and forming a shape corresponding to the outer shape of a human body, or the conductive rubber material is laminated so as to form one or a plurality of conductive rubber material layers along the inner surfaces, or, as in the example described later, an uncured conductive rubber material formed in a sheet-like shape is adhered to the inner surfaces of the outer molds, then the pair of outer molds are mated to each other to define a hollow part by the conductive rubber material and the hollow part of the conductive rubber material is filled with a polymeric foam material, whereby an ultra-lightweight whole-body phantom can be produced.

### Effects of the Invention

According to the whole-body phantom of the present invention, phantoms copying the whole shape of a human body in various conditions according to a standing pose, a sitting pose, a lying pose and various working poses can be obtained, and the pose can be modified variously. This makes it possible to perform accurate examination or observation of, for example, influences of electromagnetic waves, radio waves or the like on the human body in a variety of patterns, or variations in electromagnetic waves or radio waves due to the presence of the human body itself. As for the handling at the time of measurement, the phantoms are light in weight and promises good utility such as good workability. In addition, according to the whole-body phantom of the present invention, it is possible to realize a real phantom in which a fiber-reinforced plastic or conductive rubber material having electric characteristics similar to those of bones, muscle, fat and skin of a human body is laminated in two or more layers to form the inside similar to the tissues of a human body, so as to enable realer measurement extremely resembling the influences of electromagnetic waves, radio waves or the like on the human body or variations in electromagnetic waves or radio waves due to the presence of the human body or bodies. Thus, it is made possible to observe, for example, influences of electromagnetic waves or radio waves on the inside of the human body.

According to the process for producing a whole-body phantom of the present invention, the rubber base can be easily molded into a complicated shape such as the whole shape of a human body, so that a whole-body phantom molded from a conductive rubber material so as to copy the whole shape of a human body can be produced favorably. Particularly, according to the process for producing a whole-body phantom of the present invention in which an outer mold made of a fiber-reinforced plastic and corresponding to the outer shape of a human body and an inner mold made of a fiber-reinforced plastic and corresponding to the outer mold are used, it is possible to favorably produce a whole-body phantom with a hollow-shaped fiber-reinforced plastic molded body incorporated therein, or, further, a whole-body phantom in which a hollow part of a fiber-reinforced plastic molded body is filled with a conductive rubber material or a polymeric foam material. According to this production process, it is possible, for example, by only changing the size of the inner mold relative to the outer mold, to easily vary the thickness of the conductive rubber material, with the accuracy of thickness of the conductive rubber material being excellent. Therefore, it is possible to produce a whole-body phantom corresponding to an objective frequency. In addition, an ultra-lightweight whole-body phantom can be produced by a process in which an uncured conductive rubber material having an uncured rubber base loaded with a conductive filler is additionally provided along the inner surfaces of outer molds made of a fiber-reinforced plastic and corresponding to the outer shape of a human body when mated to each other, the outer molds are mated to each other so as to form a hollow part, and the hollow part of the conductive rubber material is filled with a polymeric foam material.

### Brief Description of the Drawings

[FIG. 1] FIG. 1 is a schematic view of a whole-body phantom for illustrating one configuration example of the present invention.
[FIG. 2] FIG. 2 is a schematic perspective view of an upper half of the whole-body phantom in the pose of talking over a cellular phone.
[FIG. 3] FIG. 3 is a schematic perspective view of the upper half of the whole-body phantom in the pose of utilizing the mailing function of a cellular phone.
[FIG. 4] FIG. 4 is a schematic longitudinal sectional view of a lower half part of the whole-body phantom. [FIG. 5] FIG. 5 is a schematic view of a whole-body phantom in a production process illustrating a configuration example of the process for producing a whole-body phantom according to the present invention.
[FIG. 6] FIG. 6 is a schematic front view of an inner mold of the whole-body phantom.
[FIG. 7] FIG. 7 shows side views of a lower half part of a whole-body phantom copying the shapes of a lower half of a human body in various poses, wherein (a) corresponds to a sitting (seated) pose, (b) corresponds to the pose of driving an automobile, and (c) corresponds to the pose of riding a motorcycle.
[FIG. 8] FIG. 8 is a sectional view illustrating a material configuration example of a whole-body phantom according to the present invention, which is a schematic view of a part corresponding to a cross section along line II-II of FIG. 4.

### Description of Reference Numerals

A: Whole-body phantom
3, 3': Right arm part (arm part)
4, 4', 4": Left arm part (arm part)
4a, 4'a: Hand
4b, 4'b: Wrist portion (attaching/detaching position between hand and arm)
9: Fiber-reinforced plastic molded body (inner mold)
10: Conductive rubber material
10a: Conductive rubber material having electric characteristics equivalent to those of muscle
10b: Conductive rubber material having electric characteristics equivalent to those of fat
10c: Conductive rubber material having electric characteristics equivalent to those of skin
11: Hollow part
12: Out mold

### Best Mode for Carrying Out the Invention

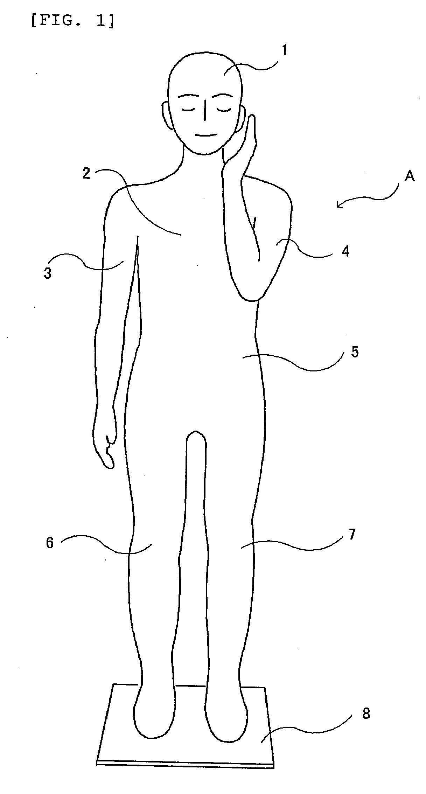

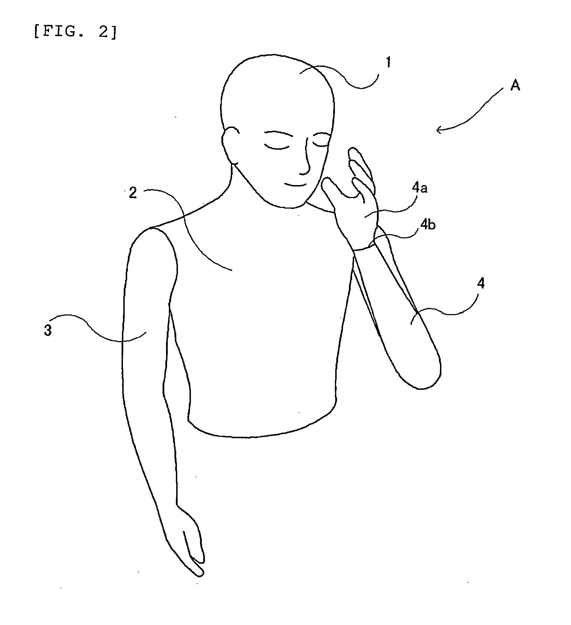

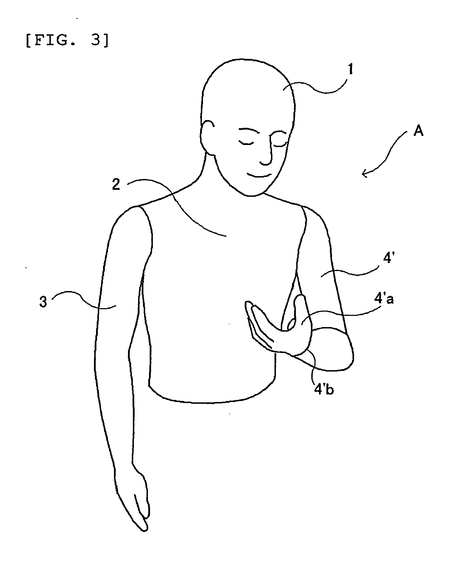

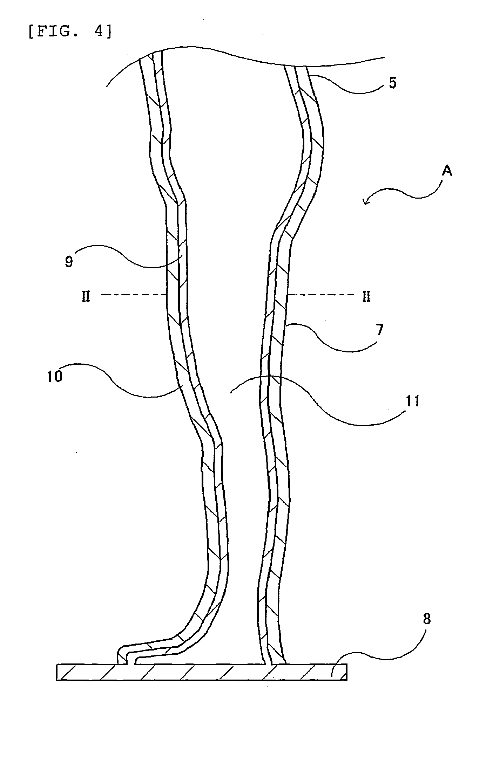

Now, the present invention will be described more in detail below referring to the drawings. FIG. 1 is a schematic general view, from substantially the front side, of a whole-body phantom A for illustrating one configuration example of the whole-body phantom according to the present invention. FIG. 2 is a schematic perspective view of an upper half of the whole-body phantom A in the pose of talking over a cellular phone as one configuration example of the present invention. FIG. 3 is a schematic perspective view of the upper half of the whole-body phantom A in the pose of utilizing the mailing function of a cellular phone as one configuration example of the present invention. FIG. 4 is a schematic longitudinal sectional view of a part corresponding to a lower half of the whole-body phantom A. The whole-body phantom A is a standing-type whole-body phantom which includes a head part 1, a chest part 2, a right arm part 3, a left arm part 4, a waist part 5, a right leg part 6, and a left leg part 7, and which is used in a standing pose at the times of measurement and observation. The whole-body phantom A is accompanied by a base 8 for preventing accidents, for example, tumbling on a measurement rotary stage at the time of measurement.

The whole-body phantom A may be one in which the head part 1, the chest part 2, the right arm part 3, the left arm part 4, the waist part 5, the right leg part 6, and the left leg part 7 are molded integrally. Or, the whole-body phantom A may be one in which the head part 1 and the chest part 2 are integrally molded to form the upper half of a human body, while the waist part 5 and the right leg part 6 and the left leg part 7 are integrally molded to form the lower half of a human body, at least one of the lower half part and the right arm part 3 and the left arm part 4 is preliminarily molded in a plurality of shapes corresponding to various poses so that at least one of the lower half and the right arm and the left arm assumes various poses, the upper half part and the lower half part are joined or firmly attached to each other by joining means or firmly attaching means or they are detachably attached to each other by engaging means or fitting means, and the right arm part 3 and the left arm part 4 may be joined or firmly attached to the chest part 2 by joining means or firmly attaching means or they may be detachably attached to the chest part 2 by engaging means or fitting means. Or, in the left arm part 4, a plurality of hand parts in different shapes corresponding to various working forms may be prepared, and only the hand may be detachably attached to the left arm part 4 at the wrist part by the same means as above-mentioned. Incidentally, the joining means, the firmly attaching means, the engaging means and the fitting means are not particularly limited in kind or configuration, and they can be selected, as required, from known members according to the layer configuration of the whole-body phantom A which will be described later. For example, the joining means is preferably liquid silicone rubber or the like, and the firmly attaching means is more preferably an adhesive, a detachable fixture or the like. Examples of the engaging means for detachable attachment include engaging members composed of a combination of a member having a slender pipe-like part with a member having a rod-like part which can be inserted into the pipe-like part and the like. Incidentally, each component of the above-mentioned means is preferably formed of a material which has little influence on electromagnetic waves. Examples of such material include low-permittivity materials such as plastic materials (e.g., fiber-reinforced plastics), reinforced plastics and the like.
In addition, the base 8 may be molded integrally with the soles of feet of the right leg part 6 and the left leg part 7. Or, alternatively, the base 8 may be molded separately from the right leg part 6 and the left leg part 7 and may be firmly attached to or detachably attached to the latter by the above-mentioned means.

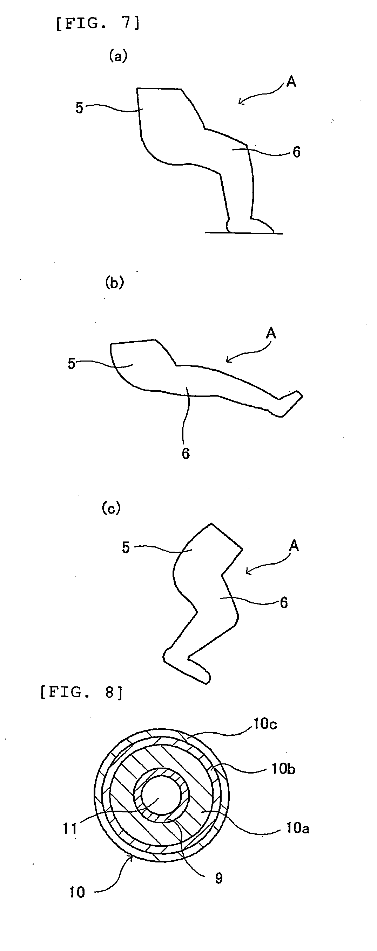

It suffices that the shape of the whole-body phantom A is designed so as to copy the shape of a human body. The human body model in this case may be male or female. Besides, the model may be an infant, a boy, a girl, an adult, an old man, a pregnant woman, a standard somatotype, a slender somatotype, a fat somatotype, or the like. Further, the whole-body phantom A may be designed so as to copy various somatotypes (physiques) such as Japanese standard somatotype, Western standard somatotype and the like. In addition, the whole-body phantom A may be designed so as to copy human body shapes in various conditions in everyday life, such as a standing posture, a sitting posture (the state of being seated on a chair or sitting on a floor), the state of driving a car, the condition of being seated on a seat (saddle) of such a vehicle as motorcycle and bicycle, a lying state, etc. For example, where the upper half part and the lower half part of the whole-body phantom A are configured to be detachably attached to each other and where the lower half part is prepared in various shapes copying the lower half parts in various conditions as the lower half parts of the whole-body phantom A shown in (a) to (c) of FIG. 7, whole-body phantoms copying various poses can be obtained according to the purpose of measurement, by only replacing the lower half part. In FIG. 7, the lower half part of the whole-body phantom A of (a) represents a lower half of the body copying the shape in a sitting posture, the lower half part of the whole-body phantom A of (b) represents a lower half of the body copying the shape in driving an automobile, and the lower half part of the whole-body phantom A of (c) represents a lower half of the body copying the shape in riding on a motorcycle.

Further, where the chest part 2 and the right arm part 3 and the left arm part 4 are configured to be detachably attached to each other, while the left arm part 4 is formed in a shape copying the state of talking over a cellular phone, as shown in FIG. 2, and the left arm part 4' is prepared as one copying the state of utilizing the mailing function of a cellular phone, as shown in FIG. 3, whole-body phantoms assuming these poses can be obtained by only replacing the left arm part 4 by the left arm part 4' or vice versa. Furthermore, where the parts of the hands 4a, 4'a in the left arm parts 4, 4' are configured to be detachably attached to the left arm parts 4, 4' at the wrist parts 4b, 4'b, efficient and accurate tests can be carried out by changing over the gripping shape of the hand according to different types of cellular phones. With the parts of the hands 4a, 4'a thus designed to be detachable, the positional relations of the hand gripping a specified cellular phone with the left arm part and the head part can be kept in a predetermined condition, whereby the accuracy and reliability of measurement results can be enhanced. For example, data on various types of cellular phones can be obtained by a method in which the speaker of a cellular phone is located near the center of an ear, while the main body of the cellular phone is located in contact with or at a fixed distance from the face surface corresponding to the cheekbone, and the angle formed between the horizontal plane containing the shoulder line and the center line of the upper arm is set at a desired angle, for example, an angle in the range of 25° to 70°, or set to a plurality of angles such as 30°, 35°, 40°, and 45°.

The whole-body phantom A is molded from a conductive rubber material having a rubber base loaded with a conductive filler by molding the rubber material so as to copy the whole shape of a human body in various poses, as above-mentioned. More specifically, as shown in FIG. 4, a conductive rubber material 10 is laminated on the surface of a hollow-shaped fiber-reinforced plastic molded body 9 molded to copy the whole shape of a human body. The reinforcing function of the fiber-reinforced plastic molded body 9 makes it possible to maintain the shape of the whole-body phantom A even when the shape corresponds to a standing pose, for example. Incidentally, according to the purpose of measurement or observation, a hollow part 11 of the fiber-reinforced plastic molded body 9 may be filled with a conductive rubber material so as to change the weight (mass) of the whole-body phantom, for example. In addition, for enhancing the lightweightness and strength, for example, the hollow part 11 of the fiber-reinforced plastic molded body 9 may be filled with the same polymeric foam material as that used in an ultra-lightweight phantom which will be described later.

Besides, a whole-body phantom may be formed by molding the conductive rubber material into a solid shape copying the whole shape of a human body, without using the fiber-reinforced plastic molded body 9. Such a solid-shaped whole-body phantom can be favorably used in the cases where, for example, the purpose is measurement or observation in a lying posture, taking into account the influences of the mass and the inside of a human body. Further, the hollow part of a hollow-shaped conductive rubber material molded body copying the whole shape of a human body may be filled with a polymeric foam material, to obtain an ultra-lightweight solid-shaped whole-body phantom.

The thickness of the fiber-reinforced plastic molded body and the thickness of the conductive rubber material laminated thereon are not particularly limited. It is to be noted here, however, that it is possible to cope with an objective frequency by regulating the thickness of the conductive rubber material. Therefore, for example, in the case of the frequency used for cellular phones, the thickness of the conductive rubber material is preferably 20 to 40 mm, more preferably 20 to 30 mm. In the case of the frequency used for radars and the like, the thickness of the conductive rubber material is preferably 5 to 20 mm, more preferably 10 to 20 mm. In addition, taking into account the strength and utility of space, the mean thickness of the fiber-reinforced plastic molded body is preferably, for example, 1 to 3 mm, more preferably 1 to 2 mm.

The polymeric foam material for producing the ultra-lightweight phantom is not particularly limited insofar as the hollow part of the phantom can be filled with the foam material. For example, a urethane, styrene or other foam material can be injected to fill up the hollow part, to obtain the solid-shaped ultra-lightweight phantom. The method of injection may be, for example, a method in which a two-part type urethane foam material is injected from nozzles into the hollow part of the conductive rubber material by use of pumps. The ultra-lightweight phantom is lighter than the phantoms formed of gelatin or ceramic according to the related art, so that it is extremely high in handleability, and it has a bulk specific gravity of not more than 1. Specifically, a bulk specific gravity of 0.95 or below can be realized, and the bulk specific gravity is preferably 0.9 or below. An ultra-lightweight phantom with a further lower specific gravity can be formed according to the use thereof.

Incidentally, the base 8 is a component which is attached as required, and its size and shape are not particularly limited but may be appropriately selected according, for example, to the pose and size of the whole-body phantom. Taking into account the handleability of the base 8 and stability of the whole-body phantom, normally, the length and width of the base 8 are preferably about 400 to 500 mm, and the thickness of the base 8 is preferably about 10 to 20 mm. In addition, the material of the base 8 is also not particularly limited. The material is preferably a low-permittivity material which does not affect the radio-wave measurement environments. Further, taking into account the easiness of production and the like, the material is more preferably a fiber-reinforced plastic or plywood.

The conductive rubber material in the present invention is a material such that desired electric characteristics can be obtained by regulating the kinds and blending ratio of the rubber base and the conductive filler. Examples of the electric characteristics with which the conductive rubber material including the real part and the imaginary part of a complex relative permittivity desired can be provided. In the present invention, the kind of the rubber base is not particularly limited. Examples of the rubber base which can be favorably used include chloroprene rubber, silicone rubber, acrylic rubber, ethylene-propylene copolymer, butadiene-acrylonitrile copolymer, fluororubber, urethane resin, elastic epoxy resin, silicon resin, silicone-modified resin, fluororesin and the like. Taking into account the easiness of control of the electric characteristics desired (stability and dispersion of electric characteristics) and the like, particularly preferred of the just-mentioned rubber bases are silicone rubber and the like. Preferable examples of the silicone rubber include methylvinylsilicone rubber, dimethylsilicone rubber, phenylsilicone rubber, fluorosilicone rubber and the like.

Examples of the conductive filler which can be favorably used include Ketchen Black, carbon fiber, graphite, carbon nanotube, carbon microcoil and the like. Taking into account the easiness of control of the electric characteristics desired (stability and dispersion of electric characteristics) and the like, particularly preferred of the just-mentioned conductive fillers are Ketchen Black, carbon nanotube and the like.

The conductive rubber material in the present invention is preferably one that has electric characteristics similar to those of muscle, fat, skin or the like of the human body. As an index to the electric characteristics, there are adopted the real part (εᵣ') and the imaginary part (εᵣ") of complex relative permittivity and dielectric loss (tanδ = εᵣ"/εᵣ'). In the case where it is intended to control the relative permittivity of the conductive rubber in the present invention, for example, as in the control method described in Patent Document 5, a system having a polymer base (rubber base) admixed with a conductive filler, e.g., spherical carbon, flat carbon or carbon fibers with a low aspect ratio and a conductive filler composed of conductive carbon is adopted. In this system, for example, an increase in the amount of conductive carbon added causes a preferential increase in the imaginary part of the complex relative permittivity, whereby a material with an increased dielectric loss is obtained. When the polymer base is admixed with spherical carbon, flat carbon or carbon fibers having a low aspect ratio and also with conductive carbon, the real part and the imaginary part of the complex relative permittivity can be controlled within ranges broader than the ranges in which the real and imaginary parts can be regulated by single use of one of these carbon materials.
Patent Document 5: PCT Patent Publication No. WO 2006/064783, pamphlet

By thus using the conductive rubber materials having electric characteristics similar to those of muscle, fat, skin and the like of the human body, a real phantom which is more equivalent to the inside of the human body can be obtained. Here, examples of the material configuration for forming a real phantom having electric characteristics more equivalent to those of the human body will be described referring to FIG. 8. The sectional view shown in FIG. 8 is a schematic figure obtained by a method in which the section of a thigh taken along line II-II of FIG. 4 is replaced by the section of the corresponding thigh part of a real phantom, as viewed from above, for illustrating the material configuration of the real phantom. The thigh part of the real phantom shown in FIG. 8 has a configuration in which a hollow part 11 is formed in a central area thereof, and a fiber-reinforced plastic molded body 9 having electric characteristics equivalent to those of bone, a conductive rubber material 10a having electric characteristics equivalent to those of muscle, a conductive rubber material 10b having electric characteristics equivalent to those of fat, and a conductive rubber material 10c having electric characteristics equivalent to those of skin are sequentially laminated in this order from the central area side.

In the present invention, the blending (loading) ratio of the conductive filler with which the rubber base is loaded is not particularly limited but may be determined according to the electric characteristics (permittivity) desired. In the case where a low permittivity is desired, the conductive filler is added in a very small amount; on the other hand, where a high permittivity is desired, the conductive filler is added in a large amount. It is to be noted here, however, if the blending ratio of the rubber base is too low, processibility of the resulting material may be spoiled. If the addition amount of the conductive filler based on the blending amount of the rubber base is too large, processibility may be spoiled, though a high permittivity can be obtained. Taking these into account, the blending ratio of the rubber base based on the total weight (hereinafter referred to also as "mass") of the conductive rubber material is preferably not less than 30 mass% (wt.%), more preferably 30 to 97 mass% (wt.%). The addition amount of the conductive filler is preferably 3 to 70 parts by weight (hereinafter referred to as "pts.wt."), more preferably 3 to 50 pts.wt., and further preferably 3 to 20 pts.wt., based on 100 pts.wt. of the rubber base.

Incidentally, in addition to the rubber base and the conductive filler, the conductive rubber material in the present invention may be admixed also with, e.g., a metal (aluminum, silver, etc.), a metallic oxide (zinc oxide, magnesium oxide, titanium oxide, etc.), a metallic hydroxide (aluminum hydroxide, calcium hydroxide, etc.) or the like. By the addition of these materials, thermal conductivity and/or flame resistance can be imparted to the conductive rubber material, or the specific gravity of the conductive rubber material can be regulated. Besides, the conductive rubber material in the present invention can be molded by the molding method which will be described later, after the rubber base as the raw material component is admixed with a curing agent and the conductive filler and other optional components as needed and the resulting mixture is blended by use of rolls, a kneader or the like.

Examples of the conductive rubber material having electric characteristics equivalent to those of muscle of the human body include the one that has the composition given in Table 1 below. As the electric characteristics of this conductive rubber material, for example, the permittivity of a molded body (40 × 40 × 10 mm) was measured by use of a vector network analyzer (8720ES, a product by Agilent Technologies) and a dielectric probe set (85070C, a product by Agilent Technologies). Upon the measurement, the real part (εᵣ'), the imaginary part (εᵣ") and tanδ (εᵣ"/εᵣ') of the complex relative permittivity at 2 GHz of the molded body in a frequency range of 100 MHz to 20 GHz were as given in Table 1 below. Incidentally, in the following table, DY32-152U is a silicone rubber produced by Dow Corning Toray Co., Ltd.; RD-27 is a platinum catalyst produced by Dow Corning Toray Co., Ltd.; RD-7 is a hydrogensiloxane produced by Dow Corning Toray Co., Ltd.; CNT is multilayer carbon nanotube produced by Bussan Nanotech Research Institute, Inc.; and KB is ECP-600JP produced by Lion Corporation and these also apply to following tables. Besides, the molding method included the steps of admixing a silicone rubber with carbon (carbon nanotube and Ketchen Black) and a vulcanizing agent (RD-27, RD-7) by open rolls, drawing out the admixture in a sheet-like shape through the rolls, laying the resulting rubber sheet so as to adhere to the inner surface of an FRP resin mold, and heating the assembly at 100°C and normal pressure for 4 hours, to achieve molding with vulcanization.

**[Table 1]**

| | Parts by mass (pts. wt.) | Real part | Imaginary part | tanδ |
|---|---|---|---|---|
| DY32-152U | 100 | 50 | 50 | 1 |
| RD-27 | 4 | | | |
| RD-7 | 15 | | | |
| CNT | 6 | | | |
| KB | 6 | | | |

Examples of the conductive rubber material having electric characteristics equivalent to those of fat of the human body include the one that has the composition given in Table 2 below. As the electric characteristics of this conductive rubber material, for example, the permittivity of a molded body (40 × 40 × 10 mm) was measured by use of a vector network analyzer (8720ES, a product by Agilent Technologies) and a dielectric probe set (85070C, a product by Agilent Technologies). Upon the measurement, the real part (εᵣ'), the imaginary part (εᵣ") and tanδ (εᵣ"/εᵣ') of the complex relative permittivity at 2 GHz of the molded body in a frequency range of 100 MHz to 20 GHz were as given in Table 2 below. The molding method included the steps of admixing a silicone rubber with carbon (carbon nanotube and Ketchen Black) and a vulcanizing agent (RD-27, RD-7) by open rolls, drawing out the admixture in a sheet-like shape through the rolls, laying the resulting rubber sheet so as to adhere to the inner surface of an FRP resin mold, and heating the assembly at 100°C and normal pressure for 4 hours, to achieve molding with vulcanization.

**[Table 2]**

| | Parts by mass (pts. wt.) | Real part | Imaginary part | tanδ |
|---|---|---|---|---|
| DY32-152U | 100 | 9 | 9 | 1 |
| RD-27 | 4 | | | |
| RD-7 | 15 | | | |
| CNT | 2 | | | |
| KB | 2 | | | |

Examples of the conductive rubber material having electric characteristics equivalent to those of skin of the human body include the one that has the composition given in Table 3 below. As the electric characteristics of this conductive rubber material, for example, the permittivity of a molded body (40 × 40 × 10 mm) was measured by use of a vector network analyzer (8720ES, a product by Agilent Technologies) and a dielectric probe set (85070C, a product by Agilent Technologies). Upon the measurement, the real part (εᵣ'), the imaginary part (εᵣ") and tanδ (εᵣ"/εᵣ') of the complex relative permittivity at 2 GHz of the molded body in a frequency range of 100 MHz to 20 GHz were as given in Table 3 below. The molding method included the steps of admixing a silicone rubber with carbon (carbon nanotube and Ketchen Black) and a vulcanizing agent (RD-27, RD-7) by open rolls, drawing out the admixture in a sheet-like shape through the rolls, laying the resulting rubber sheet so as to adhere to the inner surface of an FRP resin mold, and heating the assembly at 100°C and normal pressure for 4 hours, to achieve molding with vulcanization.

**[Table 3]**

| | Parts by mass (pts. wt.) | Real part | Imaginary part | tanδ |
|---|---|---|---|---|
| DY32-152U | 100 | 37 | 37 | 1 |
| RD-27 | 4 | | | |
| RD-7 | 15 | | | |
| CNT | 4 | | | |
| KB | 5 | | | |

Examples of the conductive rubber material having electric characteristics equivalent to those of bones of the human body include the one that has the composition given in Table 4 below. As this conductive rubber material, for example, the permittivity of a molded body (40 × 40 × 10 mm) was measured by use of a vector network analyzer (8720ES, a product by Agilent Technologies) and a dielectric probe set (85070C, a product by Agilent Technologies). Upon the measurement, the real part (εᵣ' the imaginary part (εᵣ") and tanδ (εᵣ"/εᵣ') of the complex relative permittivity at 2 GHz of the molded body in a frequency range of 100 MHz to 20 GHz were as given in Table 1 below. The molding method included the steps of admixing a silicone rubber with carbon (carbon nanotube and Ketchen Black) and a vulcanizing agent (RD-27, RD-7) by open rolls, drawing out the admixture in a sheet-like shape through the rolls, laying the resulting rubber sheet so as to adhere to the inner surface of an FRP resin mold, and heating the assembly at 100°C and normal pressure for 4 hours, to achieve molding with vulcanization. Incidentally, in the present invention, the conductive rubber materials having electric characteristics equivalent to those of muscle, fat, skin, bones or the like of the human body are not limited to the above-mentioned composition examples. For example, various conductive rubber materials of such compositions as to have the real part (εᵣ'), the imaginary part (εᵣ") and tanδ (εᵣ"/εᵣ') of the complex relative permittivity equivalent to those of muscle, fat, skin, bones and the like of the human body can naturally be selected and used.

**[Table 4]**

| | Parts by mass (pts. wt.) | Real part | Imaginary part | tanδ |
|---|---|---|---|---|
| DY32-152U | 100 | 16 | 16 | 1 |
| RD-27 | 4 | | | |
| RD-7 | 15 | | | |
| CNT | 3 | | | |
| KB | 2 | | | |

The kind of the fiber-reinforced plastic is not particularly limited. Examples of the fibers include glass fibers, carbon fibers, aramid fibers and the like. Examples of the plastic (resin) include thermosetting resins, thermoplastic resins and the like. Specific examples of the plastic (resin) include thermoplastic resins such as unsaturated polyester resins, epoxy regin, phenolic resin, vinyl ester resins and the like, for instance, such thermoplastic resins as methyl methacrylate and the like. Of the just-mentioned materials, more preferred is a combination of glass fibers with epoxy resin, in view of strength and easiness of production steps.

The electric characteristics of the fiber-reinforced plastic are not particularly limited. However, it is preferable that the electric characteristics are equivalent to, e.g., those of bones of the human body, as above-mentioned. Taking this into consideration, the electric characteristics are preferably such that when the permittivity of a molded body (40 × 40 × 10 mm) is measured by use of a vector network analyzer (8720ES, a product by Agilent Technologies) and a dielectric probe set (85070C, a product by Agilent Technologies), the real part (εᵣ') and the imaginary part (εᵣ") and tanδ (εᵣ"/εᵣ') of the complex relative permittivity at 2 GHz of the molded body in a frequency range of 100 MHz to 20 GHz are as given in Table 5 below. The molding method included the steps of admixing an epoxy resin with Ketchen Black and carbon nanotube, stirring and deaerating the admixture by a stirring deaerator, applying the resulting composition to glass fibers repeatedly, and the composition was naturally cured at normal temperature and normal pressure, to achieve molding. Incidentally, in Table 5, the epoxy resin was Basic Liquid Type 828, a product by Japan Epoxy Resins Co., Ltd.; and the glass fiber was Glass Soft Mat #300, a product by SUNRIGHT, Inc. Besides, in the present invention, the fiber-reinforced plastic having electric characteristics equivalent to those of bones of a human body is not limited to the above-mentioned composition example. For instance, various fiber-reinforced plastics of such compositions as to have the real part (εᵣ'), the imaginary part (εᵣ") and tanδ (εᵣ"/εᵣ') of the complex relative permittivity equivalent to those of bones of the human body can naturally be selected and used.

**[Table 5]**

| | Parts by mass (pts. wt.) | Real part | Imaginary part | tanδ |
|---|---|---|---|---|
| Epoxy resin | 100 | 16 | 16 | 1 |
| Glass fiber | 30 | | | |
| CNT | 3 | | | |
| KB | 2 | | | |

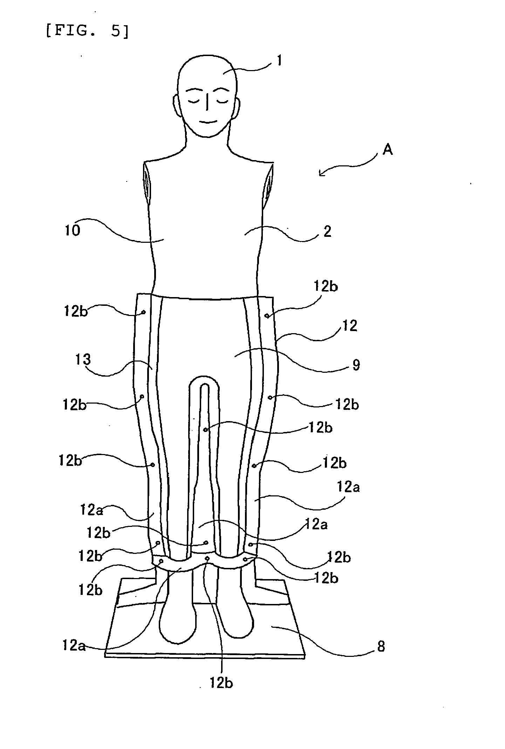

Now, the process for producing the whole-body phantom A will be described more in detail below, referring to FIG. 5. FIG. 5 is an illustration of a whole-body phantom in the production process, for illustrating a configuration example of the process for producing the whole-body phantom A according to the present invention. In this illustration, the upper half part is shown in the state after molding, with the outer mold removed. The lower half part is shown in the state before a cavity 13 between an outer mold 12 on the rear side, of a pair of outer molds corresponding to the shape of the lower half of the human body bisected into front and rear portions as will be described later, and an inner mold 9 is filled with a conductive rubber material, with the front-side outer mold removed. Incidentally, in the configuration example shown in FIG. 5, the right arm part and the left arm part of the whole-body phantom A can be detachably attached. These arm parts are similarly molded by use of respective molds, and are attached by the above-mentioned appropriate means at the time of use thereof.

The molds used in the production process according to the present invention are formed of the above-mentioned fiber-reinforced plastic, and the method of producing them is not particularly limited. For example, a plaster figure or the like copying the human body shape desired is produced by use of gypsum or the like, a mold release agent or the like is applied to the surface of the figure, as required, then an uncured fiber-reinforced plastic is laminated thereon or adhered thereto according to the physical properties and configuration thereof, and the fiber-reinforced plastic is cured by the curing method ordinarily adopted therefor, to produce the outer molds 12 made of the fiber-reinforced plastic. Here, the outer molds 12 may have such a configuration that a front-rear pair of outer molds copying the bisected front and rear shapes of the human body shape are prepared, the pair of outer molds are mated to each other into the human body shape at the time of use, and, after the curing of the conductive rubber material, the pair of outer molds can be removed splittingly. Such a configuration facilitates the mold release after molding. For this reason and the like, fixing flange parts 12a are provided and fixing member hole parts 12b for fixing members are bored in appropriate portions of the fixing flange parts 12a so as to ensure that the front-rear pair of outer molds copying the bisected human body shapes can be mated to each other to form the human body shape at the time of conducting molding. Besides, in this configuration example, for deformation of the ankle parts so as to realize easy release of the front-rear pair of outer molds, the lower half parts of the outer molds are separate from the ankle parts which are continuous with the base 8. In FIG. 5, the ankle parts and the base part are shown in the condition where the front-side outer mold is also mated. Incidentally, the fiber-reinforced plastic can be cured according to the curing method ordinarily adopted for the fiber-reinforced plastic used.

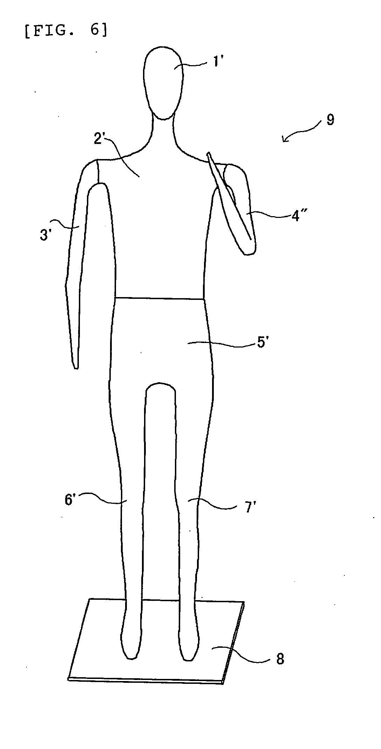

Then, for example, a clay or a clay-like rubber material or the like in a desired thickness is put on the inner surfaces of the outer molds 12 so as to realize the thickness of the conductive rubber material desired, optionally followed by applying a mold release agent thereto, an uncured fiber-reinforced plastic is laminated thereon or adhered thereto according to the physical properties and configuration thereof, and the fiber-reinforced plastic is cured by the curing method ordinarily adopted therefor, to thereby produce the inner mold (molded body) 9 made of the fiber-reinforced plastic. FIG. 6 is a schematic general view, from substantially the front side, of the inner mold 9 for illustrating a configuration example of the inner mold for the whole-body phantom according to the present invention. The inner mold 9 includes a head part 1', a chest part 2', a right arm part 3', a left arm part 4", a waist part 5', a right leg part 6', a left leg part 7' and a base 8 which correspond respectively to the relevant parts of the whole-body phantom. The head part 1' and the chest part 2' are integrally molded to form an upper half part, while the waist part 5' and the right leg part 6' and the left leg part 7' are integrally molded to form a lower half part; further, the base 8 is molded integrally with the parts corresponding to feet of the lower half part, and the right arm part 3' and the left arm part 4" are molded respectively. As shown in FIG. 6, the inner mold 9 has a configuration in which detailed parts, e.g., face surface, fingertips and the like may not necessarily be molded so as to copy the surface of the human body, but may naturally be appropriately deformed, as required. Incidentally, in FIG. 6, as the left arm part 4", one molded to correspond to the condition of talking over a cellular phone, of those molded in a plurality of shapes corresponding to various poses, is shown. The inner mold 9 may be produced by molding the respective portions of the whole-body phantom and thereafter joining, firmly attaching or detachably attaching the portions to each other, by the appropriate means as above-mentioned. In addition, for example, when the upper half and the lower half of the molds are used in the joined state at the time of molding the whole-body phantom, the upper half and the lower half of the whole-body phantom can be integrally molded. Incidentally, the inner mold also may be produced separately in the form of appropriately divided parts, or may be integrally molded. As for the thickness of the inner mold 9, the same points as those described above in regard of the fiber-reinforced plastic molded body apply. Incidentally, in the case of producing the molds by use of a fiber-reinforced plastic, the molding method therefor is not particularly limited but can be selected from among appropriate means such as a hand lay-up method, a spray-up method and the like. In addition, the fiber-reinforced plastics constituting the outer mold and the inner mold may have the same composition or different compositions. Incidentally, the inner mold 9 may be molded in bisected front and rear shapes, like the outer molds, or may be molded in a non-divided shape.

In molding the whole-body phantom A, first, a mold release agent is applied, if necessary, to the inner surfaces of the outer molds 12 having desired shapes, and the cavity 13 between the outer molds 12 and the inner mold 9 so sized to obtain the thickness of the conductive rubber material desired is filled with the uncured conductive rubber material. In this case, preferably, for example, the outer mold on one side is supplied with the conductive rubber material by lamination or application, then the inner mold is fixed, and the outer mold on the other side supplied with the conductive rubber material by lamination or application is mated thereto. Then, the conductive rubber material is cured by the curing method ordinarily adopted therefor, and the inner mold 9 is left inside the conductive rubber material, whereby it is used as the fiber-reinforced plastic molded body 9, followed by removing the outer molds 12, to obtain a whole-body phantom A in which the conductive rubber material is laminated on the surface of the fiber-reinforced plastic molded body 9. Incidentally, in the molding process shown in FIG. 5, the upper half and the lower half of the whole-body phantom A which are molded separately are shown in the state of being mated to each other. However, the upper half and the lower half may be molded integrally, or may be molded separately.

In the case of a whole-body phantom in which the hollow part of the fiber-reinforced plastic molded body 9 is filled with the conductive rubber material or a polymeric foam material, the inside of the inner mold is filled with the uncured conductive rubber material or polymeric foam material, and the conductive rubber material or the polymeric foam material is cured by the curing method ordinarily adopted therefor, whereby a solid whole-body phantom is obtained. Besides, in the case of a solid whole-body phantom composed of the conductive rubber material, only the outer molds are used, the inside of the outer molds is filled with the uncured conductive rubber material, and the conductive rubber material is cured by the curing method ordinarily adopted therefor, whereby the whole-body phantom is obtained. In this case, by controlling the specific gravity of the rubber material used to fill the inside of the outer molds, a whole-body phantom having a weight as desired can be obtained; for example, a whole-body phantom close to a human body in weight can also be obtained.

In a process for producing an ultra-lightweight whole-body phantom in which a hollow part of a conductive rubber material molded so as to copy the whole shape of a human body is filled with a polymeric foam material, preferably, the conductive rubber material having an uncured rubber base loaded with a conductive filler is applied to, laminated on or laid along the inner surfaces of a pair of outer molds made of a fiber-reinforced plastic and forming a shape to copy the whole shape of a human body when mated, the outer molds are mated to each other to define the hollow part by the conductive rubber material, and the hollow part is filled with the polymeric foam material. In this case, a mode may be adopted in which the cavity between each of the outer molds made of a fiber-reinforced plastic and corresponding to the outer shape of a human body and the inner mold made of a fiber-reinforced plastic and corresponding to the outer mold is filled with the uncured conductive rubber material, the conductive rubber material is cured, the inner mold is removed, then the outer molds are mated to each other to define a hollow part by the cured conductive rubber material, and the hollow part is filled with the polymeric foam material. Another mode may also be adopted in which the inner mold is removed before curing the conductive rubber material, the outer molds are mated to each other to define a hollow part by the uncured conductive rubber material, the hollow part is filled with the polymeric foam material, and then curing is conducted. Or, a further mode may be adopted in which not any inner mold is used, the uncured conductive rubber material is additionally provided (applied, laminated, or laid) in a predetermined thickness along the inner surfaces of outer molds, the outer molds are mated to each other to define a hollow part by the uncured conductive rubber material, the hollow part is filled with a polymeric foam material, and then curing is conducted. Yet another mode may also be adopted in which not any inner mold is used, the uncured conductive rubber material is additionally provided (applied, laminated, or laid) in a predetermined thickness along the inner surfaces of outer molds, the outer molds are mated to each other, followed by curing to define a hollow part by the cured conductive rubber material, and the hollow part is filled with the polymeric foam material. By thus producing the whole-body phantom filled with the polymeric foam material without leaving any inner mold, it is possible to produce a whole-body phantom which is further ultra-lightweight and satisfactory in handleability.

The whole-body phantom A can be favorably used as a phantom model which can assume various poses at the time of examination of the relations between a human body and various radio waves, electromagnetic waves or the like. Specifically, for example, when the conductive rubber material 10 laminated on the surface of the fiber-reinforced plastic molded body 9 is provided with desired electric characteristics, the whole-body phantom can be used as a high-frequency wave phantom. In addition, when a sensor, a measuring instrument or the like is disposed in the hollow part 11 of the fiber-reinforced plastic molded body 9 of the whole-body phantom A, the influences of electromagnetic waves exerted on the inside of a human body from the outside of the human body can be examined. Further, a whole-body phantom in which the hollow part 11 of the fiber-reinforced plastic molded body 9 is further filled with the conductive rubber material can be used as a whole-body phantom model which can assume various poses. Particularly, when the fiber-reinforced plastic is provided with electric characteristics similar to those of bones of the human body, the whole-body phantom is of better use as a low-frequency wave phantom. Besides, a whole-body phantom in which the hollow part 11 of the fiber-reinforced plastic molded body 9 is further filled with the polymeric foam material can be used as a whole-body phantom model which has strength, is light in weight, and has good handleability. Incidentally, a solid whole-body phantom formed of the conductive rubber material can be favorably utilized as a lying-type whole-body phantom. In addition, by controlling the pose and weight of the whole-body phantom A, the whole-body phantom A can be favorably used not only for electromagnetic wave measurement but also as a human body-shaped model for product designing or the like. Where the whole-body phantom is used as a human body-shaped model, its fixed shape and elasticity permit repeated use of the model and promises reproducibility of tests.

Incidentally, the present invention is not limited to the above configurations, and various modifications are possible without departure from the gist of the invention.

### Examples

Now, the present invention will be described specifically by showing examples, which are not limitative of the invention.

### [Original Shape of Whole-Body Phantom]

First, patterns (plaster figures) were formed by use of gypsum to obtain the shapes of the parts described below. As for the shape of the upper half (head part + chest part) of the human body, the average head girth 58 cm of 30-year-old Japanese males was taken as a model, and, as for the look of the face, an intermediate image between the Japanese and the Westerners was adopted. As for the chest part, a chest girth of 93.5 cm calculated from the average stature and the average body weight 65 kg of 30-year-old Japanese Males was taken as a model, and a waist girth was assumed to be 86 cm based on the model. The arm parts were of the detachably attached type detachably attached to a trunk, and two types of left arm parts were prepared, one being in the pose of talking over a cellular phone and the other being in the pose of utilizing the mailing function of the cellular phone. The thickness of the arms was estimated from the stature and the body weight. The palm size was determined by setting one of the present inventors to be a shape model, and the position of the hand was set to be the expected position of the hand in the state of using a foldable-type cellular phone. In the case of the talking type, as shown in FIG. 2, the hand was set in a supposed shape of the hand in the state of holding the cellular phone close to the head. In the case of the mailing type, as shown in FIG. 3, the hand was set in a supposed shape of the hand in the state of holding the cellular phone on an extension of a center line of the trunk (near the left chest part). The right arm part was set in a shape of one type, determined by assuming the state of naturally extending down along the side of the body as shown in FIGS. 2 and 3. As for the lower half (waist + legs) of the human body, the hip girth was set at a value of 93.5 cm, calculated from the above model, and the inside leg length was set at a value of 70.5 cm, calculated from the average stature of 30-year-old Japanese males. The foot size was set at 26 cm, the average size of Japanese males who are 160 to 170 cm tall. Besides, in order that the whole-body phantom would not tumble even when used in the pose of standing on a measurement rotary stage in an anechoic chamber, for example, a fiber-reinforced plastic base being square (450 mm × 450 mm) and having a thickness of 12 mm was integrally molded at the feet of the whole-body phantom.

### [Outer and Inner Molds]

Next, by using the above-mentioned plaster figure and a fiber-reinforced plastic (the epoxy resin used was Basic Liquid Type 828, a product by Japan Epoxy Resins Co., Ltd., and the glass fiber used was Glass Soft Mat #300, a product by SUNRIGHT, Inc.), outer molds were produced which had such shapes that they correspond to pairs of bisected front and rear shapes of parts of the whole-body phantom and they have inner walls having the shapes of the parts when the paired ones of them are mated to each other. Then, by using the fiber-reinforced plastic, the inner molds 9 shown in FIG. 6 corresponding to the parts of the whole-body phantom were produced so that the thickness of the inner molds themselves was 2 mm, that the thickness of the conductive rubber material would be 3 mm, and that the molds have the composition and electric characteristics as shown in Table 5 above. Incidentally, the molding method included the steps of applying the epoxy resins to glass fibers repeatedly and having the composition naturally cured at normal temperature and normal pressure to achieve molding.

### [Example 1]

As the conductive rubber, the one having the composition given in Table 6 below was used. Incidentally, the electric characteristics of the conductive rubber material of this composition were such that when the permittivity of a molded body (40 × 40 × 10 mm) was measured by use of a vector network analyzer (8720ES, a product by Agilent Technologies) and a dielectric probe set (85070C, a product by Agilent Technologies), the real part (εᵣ') and the imaginary part (εᵣ") and tanδ (εᵣ"/εᵣ') of the complex relative permittivity at 2 GHz of the molded body in a frequency range of 100 MHz to 20 GHz were as given in Table 6 below. The conductive rubber material was formed into a sheet-like shape, like the above-mentioned composition examples, the sheet-like rubber material was adhered to the inner surfaces of the outer molds, the inner molds were set in position, and the rubber material was cured by heating the outer molds to a temperature of 50 to 80°C by an electric heater. Thereafter, the outer molds were removed, while leaving the inner molds in situ, to obtain a whole-body phantom.

**[Table 6]**

| | Parts by mass(pts. wt.) | Real part | Imaginary part | tanδ |
|---|---|---|---|---|
| DY32-152U | 100 | 50 | 50 | 1 |
| RD-27 | 4 | | | |
| RD-7 | 15 | | | |
| CNT | 6 | | | |
| KB | 6 | | | |

### [Example 2]

A conductive rubber material provided with the electric characteristics shown in Table 3 above and formed into a sheet-like shape 0.5 mm in thickness was adhered to the inner surfaces of the above-mentioned front and rear outer molds, then a conductive rubber material provided with the electric characteristics shown in Table 2 above and formed into a sheet-like shape 4.5 mm in thickness was adhered to the inner surfaces of the assembly, and further a conductive rubber material provided with the electric characteristics shown in Table 1 above and formed into a sheet-like shape 25 mm in thickness was adhered to the inner surfaces of the assembly. Next, fiber-reinforced plastic inner molds having the electric characteristics shown in Table 5 above were used as aggregate, and, while leaving the inner molds inside, the front outer mold and the rear outer mold were mated to each other. Subsequently, the outer molds were entirely heated at a temperature in the range of 50 to 80°C by an electric heater disposed on the outside, to effect curing, and then the outer molds were removed. Consequently, a real phantom having electric characteristics similar to those of the human body, even on an inside basis, was obtained in which the fiber-reinforced plastic material and the conductive rubber materials having electric characteristics similar to those of the bone, muscle, fat, and skin of the human body were sequentially laminated in this order from the inner side.

### [Example 3]

A conductive rubber material having the electric characteristics shown in Table 1 above and formed into a sheet-like shape 30 mm in thickness was adhered to the inner surfaces of the above-mentioned front and rear outer molds, and the front and rear outer molds were mated to each other. A urethane foam material (product name: "Instapak," a product by Sealed Air Japan Ltd.) was injected into the hollow part defined inside the outer molds to fill up the hollow part, and curing was effected by heating at a temperature in the range of 50 to 80°C by an electric heater, followed by removing the outer molds. As a result, an ultra-lightweight whole-body phantom with a bulk specific gravity of 0.9 was obtained.

The whole-body phantoms in Examples 1 to 3 above are each a whole-body phantom which can be used as a pseudo human body effective for measurement, in an anechoic chamber, of the influences of electromagnetic waves in the frequency band for cellular phones in the vicinity of the human body, and for measurement of influences of the human body or bodies in a quasi-enclosed space surrounded by walls or metals, such as the inside of a room, a tramcar, an aircraft, a bus, an automobile, an elevator and the like.

### Industrial Applicability

The present invention is applicable to examination of the influences of communication-related apparatuses on the human body. Specifically, the invention is applicable, for example, to observation of the influences of a cellular phone to the human body. In addition, the invention is applicable to examination of the influences of radio waves or electromagnetic waves emitted from electromagnetic cookers, personal computers, various radars, etc. on the human body. Further, the invention is applicable to examination of the influences of electromagnetic waves on a pacemaker, for example. Furthermore, the present invention enables designing of apparatuses optimum for the human body.

## Claims

1. A whole-body phantom obtained from a conductive rubber material comprising a rubber base loaded with a conductive filler by molding said conductive rubber material so as to copy the whole shape of a human body.

2. The whole-body phantom as set forth in claim 1, wherein said conductive rubber material is laminated on a surface of a hollow-shaped fiber-reinforced plastic body molded so as to copy the whole shape of a human body.

3. The whole-body phantom as set forth in claim 2, wherein the hollow part of said fiber-reinforced plastic molded body is further filled with said conductive rubber material or a polymeric foam material.

4. The whole-body phantom as set forth in claim 1, obtained by molding said conductive rubber material into a solid shape so as to copy the whole shape of a human body.

5. The whole-body phantom as set forth in claim 1, obtained by molding said conductive rubber material so as to copy the whole shape of a human body and to have a hollow part, and filling said hollow part with a polymeric foam material so as to form a solid shape copying the whole shape of the human body.

6. The whole-body phantom as set forth in any one of claims 1 to 5, wherein a part corresponding to an arm can be detachably attached to a part corresponding to a trunk.

7. The whole-body phantom as set forth in any one of claims 1 to 6, wherein a part corresponding to an upper half of the human body and a part corresponding to a lower half of the human body can be detachably attached to each other.

8. The whole-body phantom as set forth in any one of claims 1 to 7, wherein said conductive rubber material has electric characteristics similar to those of muscle, fat or skin of a human body.

9. The whole-body phantom as set forth in any one of claims 2, 3 and 6 to 8, wherein said fiber-reinforced plastic has electric characteristics similar to those of bones of a human body.

10. The whole-body phantom as set forth in claim 8 or 9, obtained through lamination of at least two materials selected from the group composed of said conductive rubber material having electric characteristics similar to those of muscle, fat or skin of a human body and said fiber-reinforced plastic having electric characteristics similar to those of bones of a human body.

11. A process for producing a whole-body phantom as set forth in any one of claims 1 to 10, wherein a mold made of a fiber-reinforced plastic and corresponding to the outer shape of a human body is used.

12. The process for producing a whole-body phantom as set forth in claim 11, comprising the steps of filling the space between an outer mold made of a fiber-reinforced plastic and corresponding to the outer shape of a human body and an inner mold made of a fiber-reinforced plastic and corresponding to said outer mold with an uncured conductive rubber material having an uncured rubber base loaded with a conductive filler, curing the conductive rubber material, and leaving said inner mold inside said cured conductive rubber material.

13. The process as set forth in claim 12, further comprising the step of filling a hollow part defined by said inner mold with said conductive rubber material or a polymeric foam material.

14. The process as set forth in claim 11, wherein a conductive rubber material having an uncured rubber base loaded with a conductive filler is applied to, laminated on or laid along inner surfaces of a pair of outer molds formed of a fiber-reinforced plastic and corresponding to the outer shape of a human body when mated to each other, said outer molds are mated to each other so as to define a hollow part by said conductive rubber material, and said hollow part is filled with a polymeric foam material.
